(19) Europäisches Patentamt
European Patent Office
Office européen des brevets

(11) **EP 2 809 134 A2**

(12) **EUROPEAN PATENT APPLICATION**

(43) Date of publication:
**03.12.2014 Bulletin 2014/49**

(51) Int Cl.:
***H05K 1/02*** *(2006.01)*

(21) Application number: **14169446.3**

(22) Date of filing: **22.05.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **29.05.2013 JP 2013113220**

(71) Applicant: **Funai Electric Co., Ltd.**
**Daito city**
**Osaka 574-0013 (JP)**

(72) Inventors:
• **Tamai, Ryuichi**
  **Osaka, Osaka 574-0013 (JP)**
• **Ishida, Toshiyuki**
  **Osaka, Osaka 574-0013 (JP)**

(74) Representative: **Osha Liang SARL**
**32, avenue de l'Opéra**
**75002 Paris (FR)**

(54) **Electronic device**

(57) The invention concerns an electronic device for dissipating heat generated from an electronic component including a heat dissipation tape affixed on a heat transfer path that receives transferred heat generated from the electronic component. The heat dissipation tape comprises at least one heat dissipation fin formed by folding back a portion of the heat dissipation tape.

FIG. 5

EP 2 809 134 A2

**Description**

BACKGROUND

[Technical Field]

The present invention relates generally to an electronic device, and more particularly relates to a heat dissipation structure of heat generated from electronic components provided by the electronic device.

[Related Art]

With display devices such as a liquid crystal display device, a chip on film (COF) is connected to one end of the peripheral edge of the display panel. This COF has a source driver chip implemented therein that supplies drive current to the display panel for driving the display panel. Therefore, heat dissipation tape has conventionally been affixed to the back surface side of the source driver chip of the COF to dissipate heat generated from the source driver chip (for example, see Patent Document 1).

[Documents of the RelatedArt]

[Patent Document 1] Publication of Japanese Unexamined Patent Application No. 2006-064939

SUMMARY

However, in recent years, in conjunction with lowering costs and reducing the size of display devices, the number of pixel lines responsible for one source driver chip has increased thus also increasing the amount of power consumption. With this, the amount of heat generated by one source driver chip has also increased over the conventional device. Therefore, an efficient heat dissipation structure is required to dissipate the heat generated from electronic components that generate heat, such as the source driver chip, integrated circuits, and the like.

One or more embodiments of the present invention provide an electronic device that may efficiently dissipate heat generated from electronic components.

The electronic device according to one or more embodiments of the present invention may dissipate heat generated from an electronic component. The device may include a heat dissipation tape affixed on a heat transfer path that receives transferred heat generated from the electronic component, wherein the heat dissipation tape comprises at least one heat dissipation fin formed by folding back a portion of the heat dissipation tape. In another aspect, one or more embodiments of the present invention provide a method for dissipating heat generated from an electronic component of an electronic device, wherein the method may comprise: affixing a heat dissipation tape on a heat transfer path of the electronic component, the heat transfer path receiving the heat generated from the electronic component, and providing at least one heat dissipation fin formed by folding back a portion of the heat dissipation tape

According to the configuration, for example, because the heat dissipation fin is formed by folding back a portion of the heat dissipation tape, the surface area of the heat dissipation tape may be increased. Therefore, heat generated from the electronic component may be dissipated more efficiently than when simply affixing the heat dissipation tape.

In one or more embodiments, the heat dissipation tape may include a surface area on an adhering surface of the heat dissipation tape, wherein the surface area gets larger the closer the surface area is to the electronic component.

According to this configuration, for example, the surface area of the heat dissipation tape may be larger in a location where there is more heat dissipated, and the heat may be intensively dissipated from such location. Therefore, heat generated from the electronic component may efficiently dissipate.

For example, the shape of the heat dissipation tape on the adhering surface of the heat dissipation tape may be elliptical.

According to this configuration, for example, affixing the heat dissipation tape so that the electronic component may be positioned near the center of the elliptical shape enables a larger surface area of the heat dissipation tape in a location where there is more heat dissipated.

In one or more embodiments, the electronic component may be a circuit chip mounted on a wiring substrate, and the heat dissipation tape may be affixed to a position opposing the circuit chip on a surface on an opposite side of the mounting surface of the circuit chip of the wiring substrate.

According to this configuration, for example, heat generated from the circuit chip may efficiently dissipate.

In one or more embodiments, the heat dissipation tape may comprise a plurality of heat dissipation fins formed by a portion of the heat dissipation tape being folded back, and the plurality of heat dissipation fins may extend radially from the adhering surface of the heat dissipation tape.

According to this configuration, for example, the distance from the circuit chip to each of the heat dissipation fins may be shortened. Accordingly, a greater amount of heat may be dissipated near the circuit chip. Therefore, heat generated from the circuit chip may efficiently dissipate.

In one or more embodiments, the electronic device may be a display device that displays images, and the electronic device may further include a display panel that displays images, a support member that supports the display panel from a back surface side of the display panel, a frame member made of metal that covers a peripheral edge of the display panel from a front surface side of the display panel, and a wiring substrate positioned between the support member and the frame member, one end connected to a peripheral edge of the display panel, with the circuit chip mounted, wherein at least one heat dissipation fin contacts the frame member.

According to this configuration, for example, the heat generated from the circuit chip may be communicated to a frame member via the heat dissipation fins. Therefore, heat generated from the circuit chip may efficiently dissipate.

In one or more embodiments, the electronic component may be an integrated circuit, and the heat dissipation tape is affixed to a package surface of the integrated circuit.

According to this configuration, for example, heat generated from the integrated circuit may efficiently dissipate.

The electronic device according to one or more embodiments of the present invention may include an electronic device, including an electronic component, and heat dissipation tape affixed on a heat transfer path that receives transferred heat generated from the electronic component, wherein, the heat dissipation tape has a shape where the surface area on the adhering surface of the heat dissipation tape is larger and closer to the electronic component.

According to this configuration, for example the surface area of the heat dissipation tape may be larger in a location where there is more heat dissipated, and the heat may be intensively dissipated from such location. Therefore, heat generated from the electronic component may efficiently dissipate.

One or more embodiments of the present invention may provide an electronic device that may efficiently dissipate heat generated from electronic components.

BRIEF DESCRIPTION OF THE DRAWINGS

FIG. 1 shows an external view of a display device according to one or more embodiments of the present invention.
FIG. 2 shows a block diagram illustrating a main hardware configuration of the display device according to one or more embodiments of the present invention.
FIG. 3a to 3c show a diagram illustrating one example of a source driver with heat dissipation tape affixed thereto according to according to one or more embodiments of a first example.
FIG. 4a to 4c show a diagram illustrating one example of a source driver with conventional heat dissipation tape affixed thereto.
FIG. 5 shows a side view of the source driver with heat dissipation tape affixed thereto having one fin according to one or more embodiments of the present invention.
FIG. 6 shows an exploded view of the heat dissipation tape illustrated in FIG. 5.
FIG. 7 shows a side view of the source driver with heat dissipation tape affixed thereto having two fins according to a according to one or more embodiments of the second example.
FIG. 8 shows an exploded view of the heat dissipation tape illustrated in FIG. 7.
FIG. 9 shows a side view of the source driver with heat dissipation tape affixed thereto having three fins according to according to one or more embodiments of the second example.
FIG. 10 shows an exploded view of the heat dissipation tape illustrated in FIG. 9.
FIG. 11 shows a side view of the source driver with heat dissipation tape affixed thereto illustrated in FIGS. 9 and 10.
FIG. 12 shows a side view of the source driver with heat dissipation tape affixed thereto illustrated in FIG. 3.
FIG. 13 shows a cross-sectional view along the line A-A of FIG. 1.
FIG. 14 shows a cross-sectional view along the line A-A in FIG. 1 of a display device with conventional heat dissipation tape affixed to a source driver.
FIG. 15 shows a cross-sectional view along the line A-A of FIG. 1.
FIG. 16 shows a cross-sectional view along the line A-A of FIG. 1.
FIG. 17a and 17b show a diagram illustrating one example of a source driver according to one or more embodiments of a fourth example.
FIG. 18a and 18b show a diagram illustrating one example of a conventional source driver.
FIG. 19a to 19l show diagrams illustrating examples of a heat dissipation tape.
FIG. 20 shows a side view of a source driver with a source driver chip positioned on the top end of the source driver according to one or more embodiments of the present invention.
FIG. 21 shows a side view of a source driver with a source driver chip positioned on the bottom end of the source driver according to one or more embodiments of the present invention.

FIG. 22a to 22l show diagrams illustrating examples of a heat dissipation tape according to one or more embodiments of the present invention.

FIG. 23a and 23b show a diagram for explaining a production method of the heat dissipation tape according to one or more embodiments of the present invention.

FIG. 24 shows a diagram for explaining a production method of the heat dissipation tape according to one or more embodiments of the present invention.

FIG. 25a to 25c show a diagram illustrating one example of a source driver with heat dissipation tape affixed thereto according to one or more embodiments of a fifth example.

DETAILED DESCRIPTION

Embodiments of the present invention will be described in detail hereinafter with reference to drawings. All of the embodiments described below illustrate examples of the present invention. Numerical values, shapes, compositional elements, placement of location and mode of connection of elements, and the like, are one example and are not intended to limit the present invention. The present invention is specified according to the scope of claims. Therefore, compositional elements in the following embodiments that are not described in an independent claim are not necessarily essential to achieving the present invention but are described as a configuration of various embodiments. Moreover, the figures are schematic illustrations and are not necessarily strict representations.

(First Example)

*Overall Configuration*

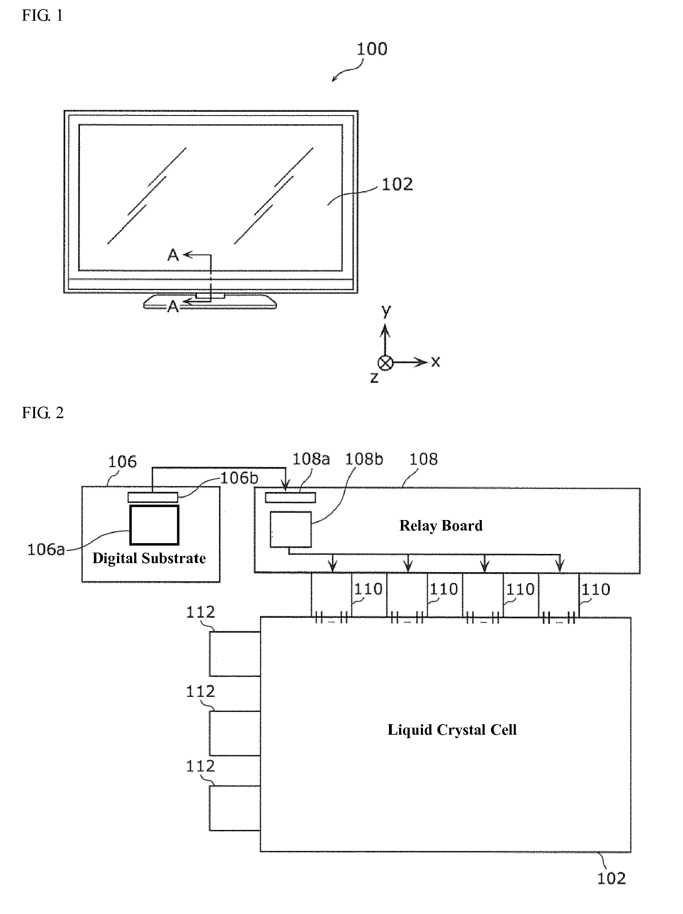

FIG. 1 is an external view of a display device according to one or more embodiments of a first example. Display device 100 is, for example, a liquid crystal display device, or a liquid crystal television receiver, that displays images on a display panel 102. In the following, the width direction, height direction, and depth direction of the display device 100 are designated as the x direction, y direction, and z direction, respectively.

FIG. 2 is a block diagram illustrating a main hardware configuration of the display device 100. The display device 100 is provided with a display panel 102, a circuit board 106, a relay board 108, a source driver 110, and a gate driver 112.

The display panel 102 is a panel for displaying images and is specifically a liquid crystal panel.

The circuit board 106 includes system large-scale integration (LSI) 106a that generates a video signal according to an image. Further, the circuit board 106 includes an interface 106b for externally transmitting the video signal generated by the system LSI 106a.

The relay board 108 is connected to the circuit board 106 and to the source driver 110 to relay the video signal generated by the circuit board 106 to the source driver 110. The relay board 108 includes an interface 108a for receiving a video signal generated by the circuit board 106 and a timing controller 108b that controls the display timing of the image.

The source driver 110 is a circuit that drives a source line of the display panel 102 by supplying source voltage to the source line of the display panel 102 according to a gradient value designated by the video signal relayed by the relay board 108. The source driver 110 is configured of a COF that has a source driver chip mounted on a flexible substrate (wiring substrate having visibility).

The gate driver 112 is a circuit that drives a gate line of the display panel 102. The gate driver 112 is configured of a COF that has a gate driver chip mounted on a flexible substrate.

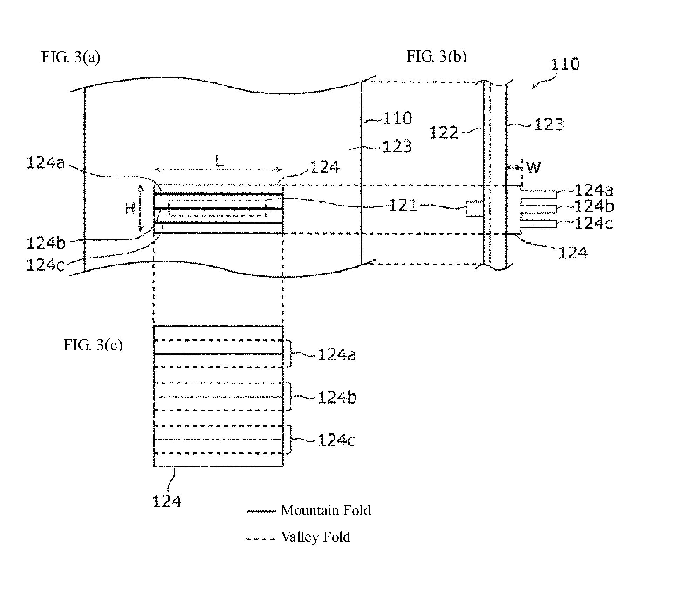

FIG. 3 is a diagram illustrating one example of the source driver 110 having heat dissipation tape affixed thereto. FIG. 3(a) is a front view of the source driver 110, and FIG. 3(b) is a side view of the source driver 110. The source driver 110 includes copper wiring 122, a source driver chip 121 mounted on the copper wiring 122, and polyimide tape 123 affixed to a surface opposite the surface where the source driver chip 121 of the two surfaces of the copper wiring 122 is mounted. Further, heat dissipation tape 124, which may be made of aluminum, is affixed in a position facing the source driver chip 121 of the polyimide tape 123. Because an adhesive is applied to the back surface of the heat dissipation tape 124 in advance, the heat dissipation tape 124 and the polyimide tape 123 can be affixed easily. The heat dissipation tape 124 has heat dissipation fins 124a to 124c. FIG. 3(c) is an exploded view of the heat dissipation tape 124. The solid line portion of the flat heat dissipation tape 124 is mountain folded, and the broken line portion is valley folded, therefore, the heat dissipation tape 124 folded in the mountain portions are bonded together to form the heat dissipation fins 124 a to 124c on the heat dissipation tape 124.

*Heat Dissipation Efficiency*

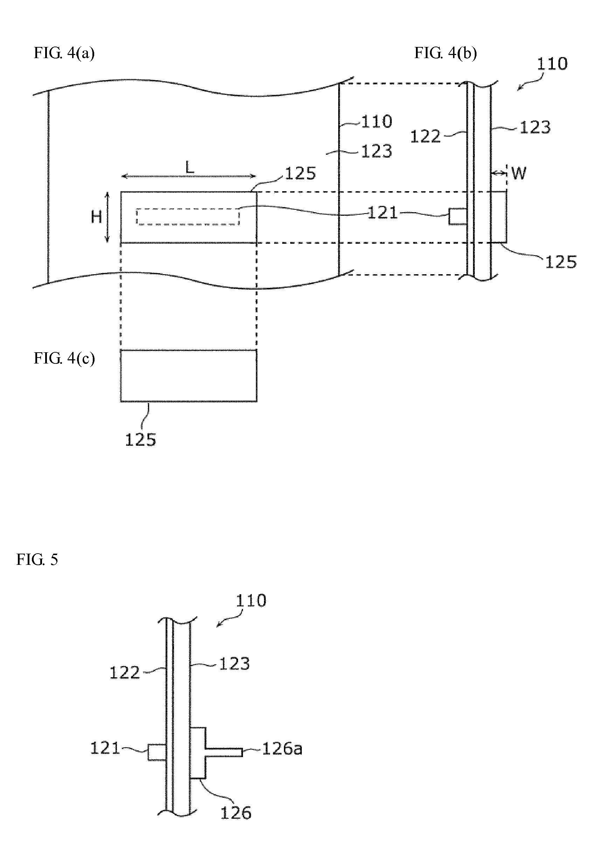

Next, the heat dissipation efficiency of the heat dissipation tape 124 will be described. Here, the length and height of the heat dissipation tape 124 on the adhering surface of the heat dissipation tape 124 are designated as L and H, respectively. Further, the width not including the heat dissipation fins 124a to 124c of the heat dissipation tape 124 (thickness) is designated as W. FIG. 4 is a diagram illustrating one example of the source driver 110 having conventional heat dissipation tape affixed thereto having the same length, height, and width as the heat dissipation tape 124. FIG. 4(a) is a front view of the source driver 110, FIG. 4(b) is a side view of the source driver 110, and FIG. 4(c) is an exploded view of the heat dissipation tape 125. The conventional heat dissipation tape 124 is not folded, and therefore, may have the same shape as the heat dissipation tape 125 illustrated in FIG. 4(a) and the heat dissipation tape 125 illustrated in FIG. 4(c).

Equation 1 is an equation expressing the temperature rise ΔT of the source driver chip 121.

$$\Delta T = P/(h \times A) \ldots \text{(Equation 1)}$$

ΔT: temperature rise of the source driver chip 121
P: heat loss [W] of the source driver ship 121
h: convective heat transfer coefficient [(W/m$^2$) °C]
A: surface area [m$^2$] of the heat dissipation tape

It can be understood from equation 1 that the temperature rise of the source driver chip 121 gets smaller as the surface area of the heat dissipation tape gets larger. Comparing the heat dissipation tape 124 and the heat dissipation tape 125, the heat dissipation tape 124 has a larger surface area by only the portion of the heat dissipation fins 124a to 124c. Therefore, affixing the heat dissipation tape 124 having the heat dissipation fins 124a to 124c to the polyimide tape 123 can suppress temperature rise of the source driver chip 121.

Each of the heat dissipation fins 124a to 124c have twice the heat dissipation efficiency, because of having twice the surface area, compared to heat dissipation tape with the same area as the heat dissipation fins but not having mountain folding.

*Modified Example*

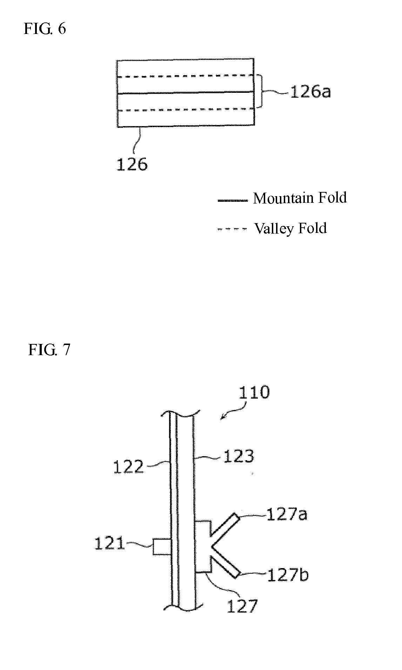

In the first example, there were three heat dissipation fins, but the number of heat dissipation fins is not limited to this and may be one or more. For example, heat dissipation tape 126 having one heat dissipation fin 126a as illustrated in FIG. 4 may be affixed in a position facing the source driver chip 121 on the polyimide tape 123. FIG. 6 illustrates an exploded view of the heat dissipation tape 126 illustrated in FIG. 5.

As described above, according to one or more embodiments of the first example, because the heat dissipation fins 124a to 124c are formed by folding back a portion of the heat dissipation tape 124, the surface area of the heat dissipation tape 124 can be increased. Therefore, heat generated from the source driver chip 121 can be dissipated more efficiently than when simply affixing the heat dissipation tape 125.

[Second Example]

In one or more embodiments of the first example, the heat dissipation tape was folded back so that a plurality of heat dissipation fins could be parallel with each other. In the second example, the heat dissipation tape is folded back so that a plurality of heat dissipation fins can extend radially from the adhering surface of the heat dissipation tape.

*Overall Configuration*

Because the configuration may be the same or substantially similar as one or more embodiments of the first example with the exception of the heat dissipation tape, a detailed description will not be repeated here.

FIG. 7 is a side view of a source driver 110. A heat dissipation tape 127 having heat dissipation fins 127a and 127b is affixed in a position facing the source driver chip 121 of the polyimide tape 123. The heat dissipation fins 127a and 127b extend radially from the position of the source driver chip 121.

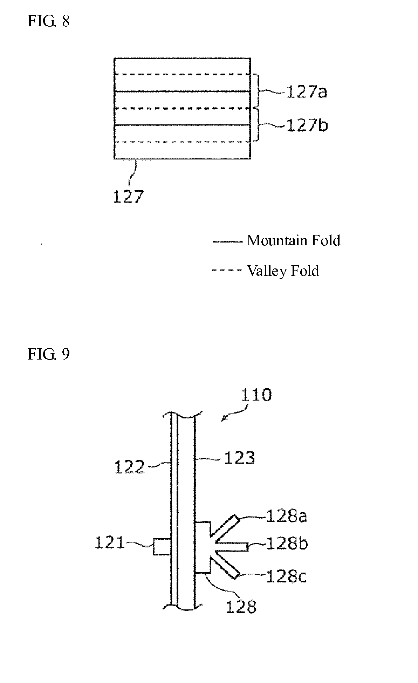

Figure 8 is an exploded view of the heat dissipation tape 127. Valley folding a single location between the heat dissipation fin 127a and heat dissipation fin 127b, enables the heat dissipation fins 127a and 127b to extend radially from the position of the source driver chip 121.

There may be a plurality of heat dissipation fins extending radially and are not limited to two. FIG. 9 is a side view of the source driver 110 with heat dissipation tape having three heat dissipation fins affixed. A heat dissipation tape 128 having heat dissipation fins 128a, 128b, and 128c is affixed in a position facing the source driver chip 121 of the polyimide tape 123. The heat dissipation fins 128a, 128b, and 128c extend radially from the position the source driver chip 121.

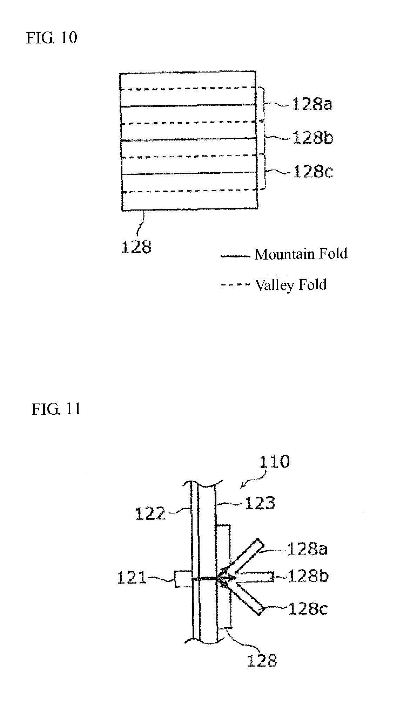

FIG. 10 is an exploded view of the heat dissipation tape 128. Mountain folding a single location between the heat dissipation fin 128a and the heat dissipation fin 128b, and mountain folding a single location between the heat dissipation fin 128a and the heat dissipation fin 128c, enables the heat dissipation fins 128a, 128b, and 128c to extend radially.

*Heat Dissipation Efficiency*

Next, the heat dissipation efficiency of the heat dissipation tape having a heat dissipation fin radially extended therefrom will be described.

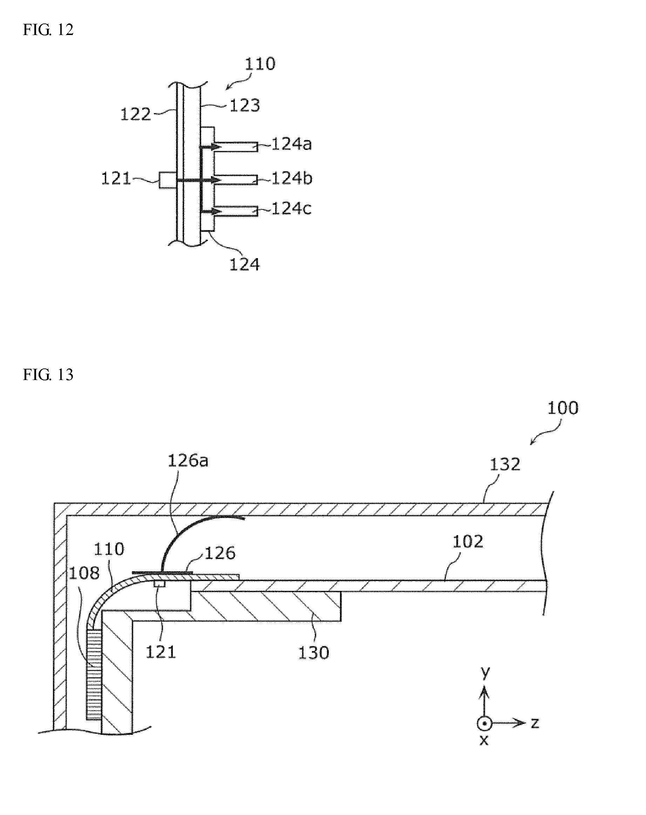

FIG. 11 is a side view of the source driver 110 with the heat dissipation tape 128 illustrated in FIG. 9 and FIG. 10 affixed thereto. FIG. 12 is a side view of the source driver 110 with the heat dissipation tape 124 illustrated in FIG. 3 of the first example affixed thereto. The arrow in FIGS. 11 and 12 indicates the transmission heat transfer path of the heat generated from the source driver chip 121. The respective distances from the source driver chip 121 to the heat dissipation fins 128a ~ 128c are approximately equal. In contrast to this, the distance from the source driver chip 121 to the heat dissipation fin 124a and the distance from the source driver chip 121 to the heat dissipation fin 124c is longer than the distance from the source driver chip 121 to the heat dissipation fin 124b. Therefore, the heat can transmit faster to the heat dissipation fin 128a when the heat dissipation fin is arranged radially.

As described above, according to one or more embodiments of the second example, the distance between the source drive chip 121 and each heat dissipation fin can be shortened. Therefore, a greater amount of heat can be dissipated near the source driver chip 121. Therefore, the heat generated from the source driver chip 121 can efficiently dissipate.

(Third Example)

In one or more embodiments of the third example, an installation method in the display device 100 will be described for the heat dissipation tape having the heat dissipation fins illustrated in the first and second examples.

FIG. 13 is a cross-sectional view cut along the line A-A of FIG. 1. FIG. 13 illustrates only the configuration of the display device 100 near the heat dissipation tape, and the illustration for the configuration of the front cabinet, rear frame, and the like provided on the display 100 has been omitted.

The display device 100 is provided with a display panel 102, a cell guide 130, a source driver 110, a relay board 108, and a bezel 132.

The display panel 102, the source driver 110, and the relay board 108 may be identical or substantially similar to those described in the first example. One end of the source driver 110 is connected to the display panel 102 and the other end is connected to the relay board 108.

The cell guide 130 is a support member made of resin that supports the display panel 102 from the back surface side of the display panel 102.

The bezel 132 is a frame member made of metal that covers a peripheral edge of the display panel from the front surface side of the display panel 102.

The heat dissipation fin 126a of the heat dissipation tape 126 illustrated in FIG. 5 is disposed to touch the bezel 132. Therefore, the heat generated from the source driver chip 121 can transmit through the heat dissipation fin 126a to the bezel 132.

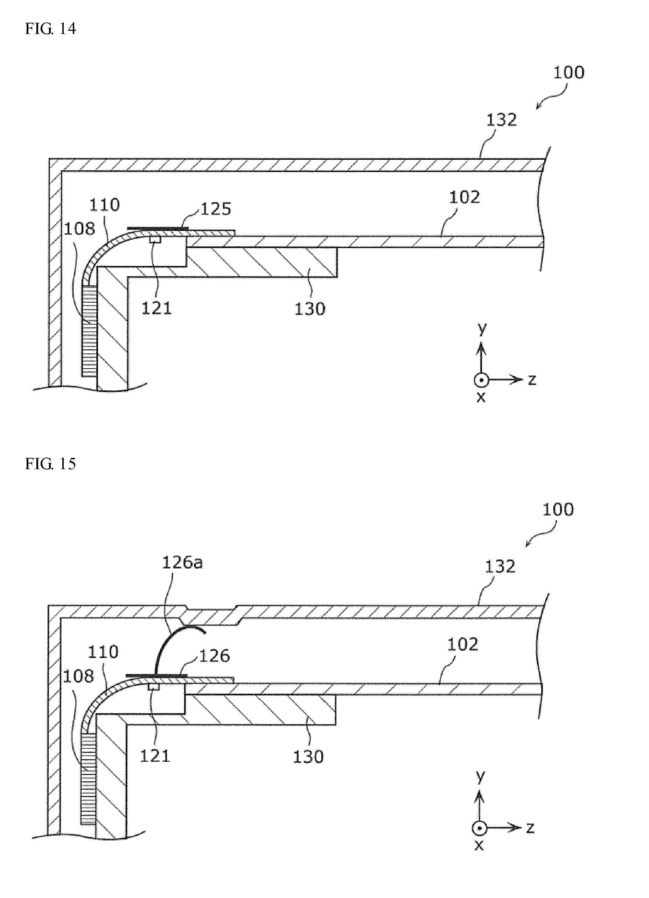

Meanwhile, the conventional heat dissipation tape 125 does not provide a heat dissipation fin. FIG. 14 is a cross-sectional view along the line A-A in FIG. 1 of the display device 100 with the conventional heat dissipation tape 125 affixed to the source driver 110. As illustrated in FIG. 14, the conventional heat dissipation tape 125 cannot come in contact with the bezel 132. Therefore, the heat generated from the source driver chip 121 cannot be transmitted to the bezel 132.

As described above, according to one or more embodiments of the third example, the heat generated from source driver chip 121 can be transmitted to the metal bezel 132 made of metal through the heat dissipation tape 126a. Therefore, the heat generated from source driver chip 121 can efficiently dissipate.

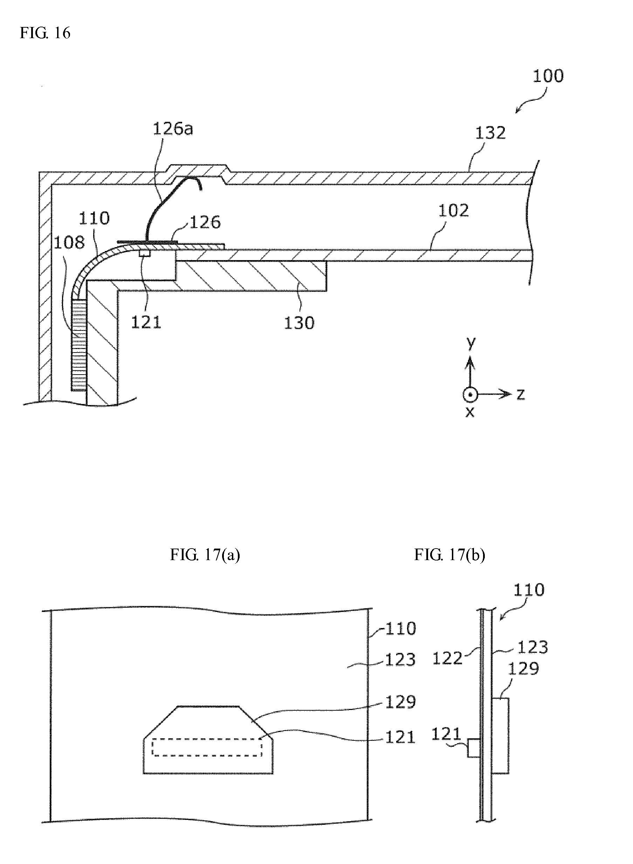

Also, the heat generated from the source driver chip 121 can be transmitted to the metal bezel 132 through the heat dissipation fin 126a regardless of the shape of the metal bezel 132. FIG. 15 and FIG. 16 are cross-sectional views along the line A-A of FIG. 1. For example, as illustrated in FIG. 15, when the bezel 132 has a shape that projects toward the display panel 102, making the heat dissipation fin 126a contact the position where the bezel 132 projects enables the heat generated from the source driver chip 121 to be transmitted to the metal bezel 132. Further, as illustrated in FIG. 16, lengthening the length of the heat dissipation fin 126a allows the heat dissipation fin 126a to contact the bezel 132 even if the bezel 132 has a shape that projects in a direction away from the display panel 102. Therefore, the heat generated from the source driver chip 121 can be transmitted to the metal bezel 132.

(Fourth Example)

One or more embodiments of the fourth example differ from one or more embodiments of the first to third examples in that the shape on the adhering side of the heat dissipation tape is not rectangular. There is also no heat dissipation fin on the heat dissipation tape in one or more embodiments of the fourth example.

*Overall Configuration*

Because the configuration may be the same or substantially similar as the first example with the exception of the heat dissipation tape, a detailed description will not be repeated here.

FIG. 17 is a diagram illustrating one example of the source driver 110. FIG. 17(a) is a front view of the source driver 110, and FIG. 17(b) is a side view of the source driver 110. A heat dissipation tape 129 is affixed in a position facing the source driver chip 121 of the polyimide tape 123. The heat dissipation tape 129 has a hexagonal shape with the top right and top left corners trimmed.

*Heat Dissipation Efficiency*

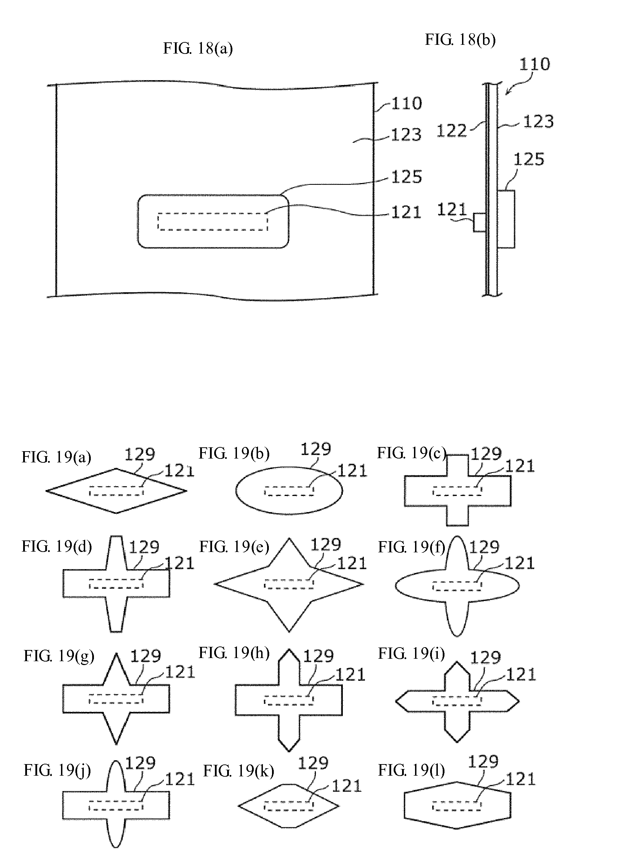

Next, the heat dissipation efficiency of the heat dissipation tape 129 will be described. For comparison, an example of a conventional source driver 110 is illustrated in FIG. 18. FIG. 18(a) is a front view of the source driver 110, and FIG. 18(b) is a side view of the source driver 110. A heat dissipation tape 125 is affixed in a position facing the source driver chip 121 of the polyimide tape 123. The shape of the heat dissipation tape 125 is rectangular. Furthermore, the area of the heat dissipation tape 125 and the heat dissipation tape 129 may be the same.

The source driver chip 121 is a heat source. Therefore, the temperature of the source driver 110 is higher the closer it is to the source driver chip 121 and is lower the further away it is from the source driver 121. The heat dissipation tape 129 illustrated in FIG. 17 has a shape that has a larger surface area on the adhering side of the heat dissipation tape 129 the closer it is to the source driver chip 121. Specifically, the width in the vertical direction of the heat dissipation tape 129 is narrower the farther away in the horizontal direction it is from the center of the source driver chip 121. In contrast to this, the heat dissipation tape 125 illustrated in FIG. 18 has a portion closer to and a portion farther away from the source driver chip 121, and the surface area on the adhering side of the heat dissipation tape 125 may be the same. Specifically, the width in the vertical direction of the heat dissipation tape 125 is fixed even when farther away in the horizontal direction from the center of the source driver chip 121.

Even with the same surface area in this manner, the heat dissipation tape 129 can be affixed to a portion with a higher temperature compared to the heat dissipation tape 125. Therefore, the heat generated from the source driver chip 121 can be effectively dissipated.

*Other Shapes of Heat Dissipation Tape 129*

The shape of the heat dissipation tap 129 is not limited to a hexagon as illustrated in FIG. 17. For example, the shape may be such as that illustrated in FIG. 19(a)-(1). What these have in common is that they have a shape in which the surface areas on the adhering side of heat dissipation tape 129 gets larger the closer it is to the source driver chip 121. That is to say, the farther away heat dissipation tape 129 is in the horizontal direction from the center of the source driver chip 121, the narrower it is in the vertical direction. For example, as illustrated in FIG. 19(b), the shape of the heat dissipation tape 129 may be an ellipse having long sides in the length direction of the source driver chip 121.

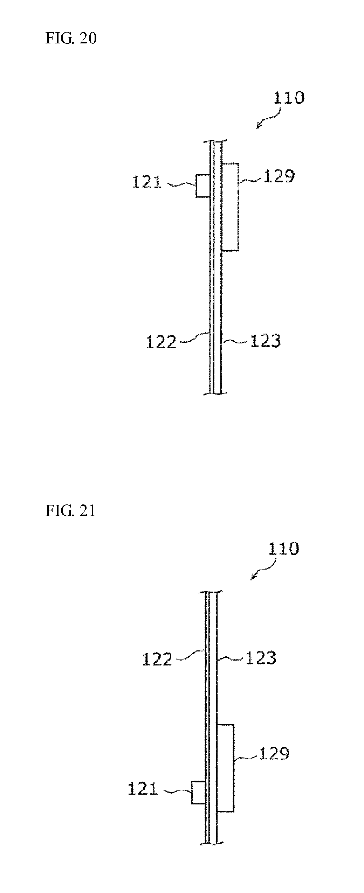

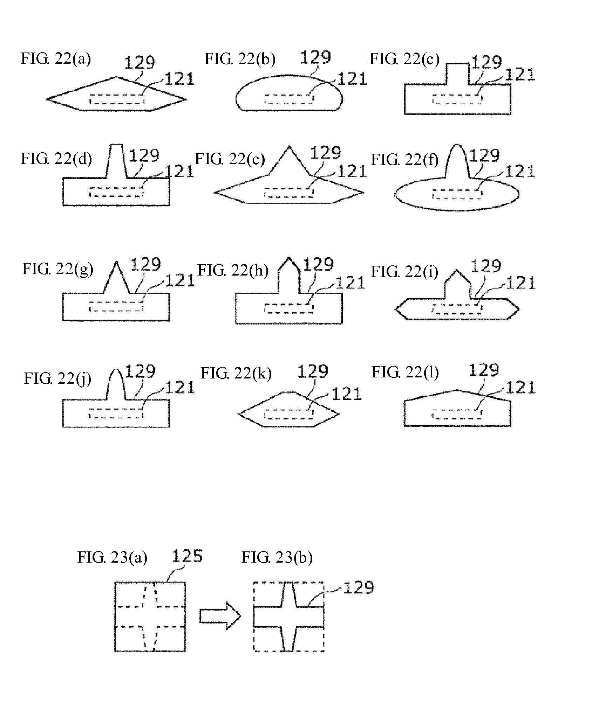

All of the shapes of the heat dissipation tape 129 illustrated in FIG. 19 have vertical symmetry. However, vertical symmetry is not necessarily required. FIG. 20 is a side view of the source driver 110 in which the source driver chip 121 is positioned on the upper end of the source driver 110, and FIG. 21 is a side view of the source driver 110 in which the source driver chip 121 is positioned on the lower end of the source driver 110. Whether the source driver chip 121 is positioned on the upper end or positioned on the lower end of the source driver 110, sufficient space on the upper side or lower side of the source driver chip 121 cannot be assured. Therefore, the heat dissipation tape 129 having vertical symmetry may not be able to be affixed in a position facing the source driver chip 121. In these cases, the heat dissipation tape 129 having vertical asymmetry can be affixed. For example, when the source driver chip 121 is in a position illustrated in FIG. 21, sufficient space on the lower side of the source driver chip 121 cannot be assured. Therefore, the heat dissipation tape 129 with a shape such as that illustrated in FIG. 22(a)-(1) may be affixed in a position facing the source driver chip 121. Heat dissipation tapes 129 such as these have a shape with a lower portion of the heat dissipation tapes 129 illustrated in FIG. 19(a)-(1) trimmed. The heat dissipation tapes 129 illustrated in FIG. 22 also have a shape that has a larger surface area on the adhering side of the heat dissipation tape 129 the closer it is to the source driver chip 121. That is to say, the farther away these heat dissipation tapes 129 are in the horizontal direction from the center of the source driver chip 121, the narrower they are in the vertical direction.

*Production Method of Heat Dissipation Tape 129*

Next, a production method of the heat dissipation tape 129 will be described. FIG. 23 is a diagram for describing a production method of the heat dissipation tape 129 illustrated in FIG. 19(d). The heat dissipation tape 129 illustrated in FIG. 23(b) is produced by trimming the four corners of the conventional rectangular shaped heat dissipation tape 125 illustrated in FIG. 23(a). If the trimmed portion does not contribute much to the heat dissipation of the source driver chip 121, a single heat dissipation tape or as many as the conventional number of heat dissipation tapes may be created.

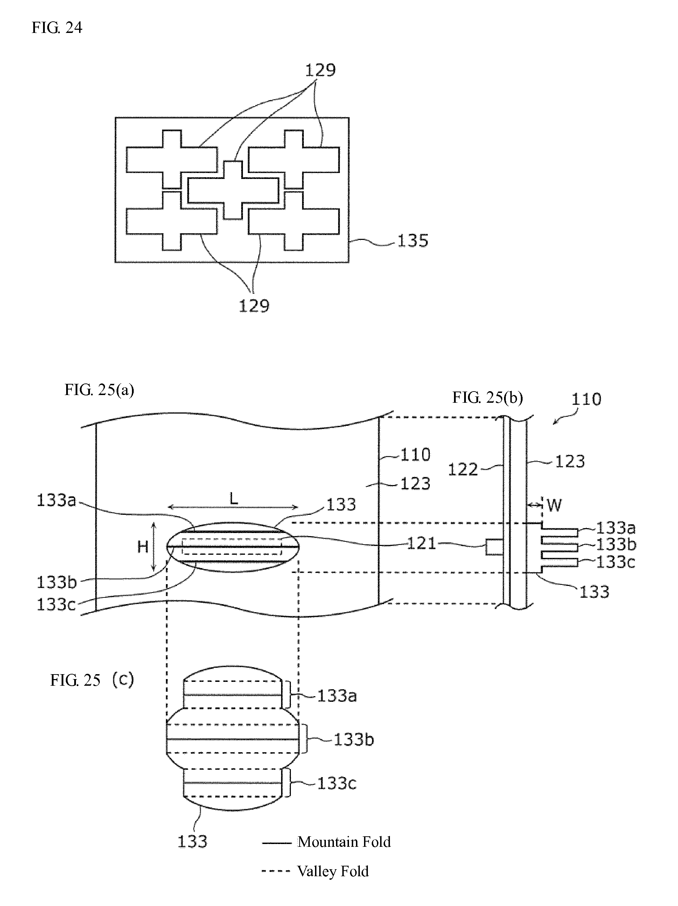

As illustrated in FIG. 24, more heat dissipation tapes 129 may be created by trimming a plurality heat dissipation tapes 129 which are arrayed in a staggered pattern from one heat dissipation tape 135, compared to when trimming the four corners of a rectangular heat dissipation tape.

As described above, according to one or more embodiments of the fourth example, the surface area of the heat dissipation tape 129 can be larger in a location where there is more heat dissipated, and the heat can be intensively dissipated from such location. Therefore, the heat generated from source driver chip 121 can efficiently dissipate.

(Fifth Example)

In one or more embodiments of the first to third examples, heat dissipation tapes having a heat dissipation fin are described. In one or more embodiments of the fourth example, a description is given of a heat dissipation tape having a shape that has a larger surface area on the adhering side the closer it is to the source driver chip 121. In one or more embodiments of the fifth example, a heat dissipation tape with both of these attributes will be described.

*Overall Configuration*

Because one or more embodiments of the fifth example may be the same as one or more embodiments of the first example with the exception of the heat dissipation tape, a detailed description will not be repeated here.

FIG. 25 is a diagram illustrating one example of the source driver 110 having heat dissipation tape affixed thereto. FIG. 25(a) is a front view of the source driver 110, and FIG. 25(b) is a side view of the source driver 110. A heat dissipation tape 133 is affixed in a position facing the source driver chip 121 on the polyimide tape 123. The heat dissipation tape 133 illustrated in FIG. 25(a) has a shape in which the surface area on the adhering side of the heat dissipation tape 133 gets larger the closer it is to the source driver chip 121, such as, an elliptical shape. That is to say, the farther away the heat dissipation tape 133 is in the horizontal direction from the center of the source driver chip 121, the narrower it is in the vertical direction. The heat dissipation tape 133 has heat dissipation fins 133a to 133c. FIG. 25(c) is an exploded view of the heat dissipation tape 133. The solid line portion of the flat heat dissipation tape 133 is mountain folded, and the broken line portion is valley folded, therefore, the heat dissipation tape 133 folded in the mountain portions are bonded together to form the heat dissipation fins 133 a to 133c.

As described above, according to one or more embodiments of the fifth example, because the heat dissipation fins 133a to 133c are formed by folding back a portion of the heat dissipation tape 133, the surface area of the heat dissipation tape 133 can be increased. Therefore, heat generated from the source driver chip 121 can be dissipated more efficiently than when simply affixing the heat dissipation tape.

Further, the surface area of the heat dissipation tape 133 may be larger in a location where there is more heat dissipated, and the heat can be intensively dissipated from such location. Therefore, the heat generated from source driver chip 121 can efficiently dissipate.

Descriptions were given above for the display device according to embodiments of the present invention, but the present invention is not limited to the embodiments described above.

For example, in one or more embodiments of the fifth example, the shape of the adhering side of the heat dissipation tape 133 was an ellipse, but it is not limited to an ellipse. For example, it may be a shape such as that illustrated in FIG. 17, FIG. 19, or FIG. 22.

Further, the heat dissipation tape may be affixed to something other than the COF. For example, it may be affixed on the package of the system LSI 106a illustrated in FIG. 2, or it may be affixed on a power transistor. Further, the heat dissipation tape may also be affixed on a metallic heat sink or the like.

Moreover, the material of the heat dissipation tape is not limited to aluminum, and it may be a metal with high thermal conductivity, such as copper or silver. Also, the heat dissipation tape may be made of silicone rubber for heat dissipation.

Further, the display device is not limited to a liquid crystal display device or a liquid crystal television receiver, but may also be an organic electro luminescence (EL) display device, an organic EL television receiver, or the like.

Targeted use of heat dissipation tape is not limited to a display device. The heat dissipation tapes described in the above embodiments may be used to dissipate heat from electronic devices such as video recorders, lighting equipment, or any electronic device that uses electronic components.

In addition, the embodiments and the modified examples above may be respectively combined.

An electronic device according to one or more embodiments of the present invention can be applied to, for example, a liquid crystal display device or a liquid crystal television receiver for displaying images.

Although the disclosure has been described with respect to only a limited number of embodiments, those skilled in the art, having benefit of this disclosure, will appreciate that various other embodiments may be devised without departing from the scope of the present invention. Accordingly, the scope of the invention should be limited only by the attached claims.

[Description of the Numerical References]

| 100 | Display device |
| 102 | Display panel |
| 106 | Circuit board |
| 106a | System LSI |
| 106b, 108a | Interface |
| 108 | Relay board |
| 108b | Timing controller |
| 110 | Source driver |
| 112 | Gate driver |
| 121 | Source driver chip |
| 122 | Copper wiring |
| 123 | Polyimide tape |
| 124, 125, 126, 127, 128, 129, 133, 135 | Heat dissipation tape |
| 124a to 124c, 126a, 1277a, 127b, 128a to 128c, 133a to 133c | Heat dissipation fin |
| 130 | Cell guide |
| 132 | Bezel |

Claims

1. An electronic device for dissipating heat generated from an electronic component, comprising:

a heat dissipation tape (124 - 129, 133, 135) affixed on a heat transfer path configured to receive transferred heat generated from the electronic component,
wherein the heat dissipation tape (124 - 129, 133, 135) comprises at least one heat dissipation fin (124a - 124c, 126a, 127a, 127b, 128a-128c, 133a-133c) formed by folding back a portion of the heat dissipation tape.

2. The electronic device according to claim 1,
wherein the heat dissipation tape (124 - 129, 133, 135) comprises a surface area on an adhering surface of the heat dissipation tape, and
wherein the surface area gets larger the closer the surface area is to the electronic component.

3. The electronic device according to claim 2,
wherein the shape of the heat dissipation tape on the adhering surface of the heat dissipation tape is elliptical.

4. The electronic device according to any of claims 1 to 3,
wherein the electronic component is a circuit chip (110) mounted on a wiring substrate, and whe
rein the heat dissipation tape (124 - 129, 133, 135) is affixed to a position facing the circuit chip (110) on a surface on an opposite side of the mounting surface of the circuit chip of the wiring substrate.

5. The electronic device according to claim 4,
wherein the heat dissipation tape (124 - 129, 133, 135) comprises a plurality of heat dissipation fins (124a - 124c, 126a, 127a, 127b, 128a-128c, 133a-133c) formed by a portion of the heat dissipation tape being folded back, and
wherein the plurality of heat dissipation fins extend radially from the adhering surface of the heat dissipation tape.

6. The electronic device according to any of claims 4 to 5,
wherein the electronic device is a display device (100) that displays images, and
wherein the electronic device further comprises:

a display panel (102) configured to display images;
a support member (130) configured to support the display panel from a back surface side of the display panel;
a frame member (132) made of metal configured to cover a peripheral edge of the display panel (102) from a front surface side of the display panel; and
a wiring substrate positioned between the support member (130) and the frame member (132), one end connected to a peripheral edge of the display panel, with the circuit chip (110) mounted,
wherein at least one heat dissipation fin (124a - 124c, 126a, 127a, 127b, 128a-128c, 133a-133c) contacts the frame member.

7. The electronic device according to any of claims 1 to 2,
wherein the electronic component is an integrated circuit, and
wherein the heat dissipation tape is affixed to a package surface of the integrated circuit.

8. An electronic device, comprising:

an electronic component configured to generate heat; and
a heat dissipation tape (124 - 129, 133, 135) affixed on a heat transfer path that receives transferred heat generated from the electronic component;
wherein the heat dissipation tape has a shape where the surface area on the adhering surface of the heat dissipation tape gets larger the closer the surface area is to the electronic component.

9. A method for dissipating heat generated from an electronic component of an electronic device, the method comprising:

affixing a heat dissipation tape (124 - 129, 133, 135) on a heat transfer path of the electronic component, the heat transfer path receiving the heat generated from the electronic component; and
providing at least one heat dissipation fin (124a - 124c, 126a, 127a, 127b, 128a-128c, 133a-133c) formed by folding back a portion of the heat dissipation tape.

10. The method according to claim 9, further comprising:

providing a surface area on an adhering surface of the heat dissipation tape (124 - 129, 133, 135) configured to get larger the closer the surface area is to the electronic component.

**11.** The method according to claim10,
wherein the shape of the heat dissipation tape (124 - 129, 133, 135) on the adhering surface of the heat dissipation tape is elliptical.

**12.** The method according to any of claims 9 to 10,
wherein the electronic component is a circuit chip mounted (110) on a wiring substrate, and the method further comprises affixing the heat dissipation tape (124 - 129, 133, 135) to a position facing the circuit chip on a surface on an opposite side of the mounting surface of the circuit chip of the wiring substrate.

**13.** The method according to claim 12, further comprising:

providing a plurality of heat dissipation fins (124a - 124c, 126a, 127a, 127b, 128a-128c, 133a-133c) formed by folding back a portion of the heat dissipation tape (124 - 129, 133, 135),
wherein the plurality of heat dissipation fins extend radially from the adhering surface of the heat dissipation tape.

**14.** The method according to claim 12,
wherein the electronic device is a display device (100) that displays images.

**15.** The method according to claim 9,
wherein the electronic component is an integrated circuit, and the method further comprises affixing the heat dissipation tape to a package surface of the integrated circuit.

FIG. 1

100

102

A

A

Y

X

Z

FIG. 2

106

106b

108a 108b 108

106a

Digital Substrate

Relay Board

110 110 110 110

112

112

Liquid Crystal Cell

112

102

FIG. 3(a)

FIG. 3(b)

110

124a

124

L

H

124b
124c

110
123

122

123

W

121

124a
124b
124c

124

FIG. 3(c)

124a

124b

124c

124

———— Mountain Fold

- - - - Valley Fold

FIG. 4(a)

FIG. 4(b)

FIG. 4(c)

FIG. 5

FIG. 6

—— Mountain Fold

- - - - Valley Fold

FIG. 7

FIG. 8

127a

127b

127

——— Mountain Fold

- - - - Valley Fold

FIG. 9

110

122    123

121

128a

128b

128c

128

FIG. 10

128a

128b

128c

128

——— Mountain Fold

- - - - Valley Fold

FIG. 11

110

122     123

121

128a

128b

128c

128

FIG. 12

FIG. 13

FIG. 14

FIG. 15

FIG. 16

FIG. 17(a)　　　　　　　　　　FIG. 17(b)

FIG. 18(a)

FIG. 18(b)

110

123

125

121

110

122

123

125

121

FIG. 19(a)

129

121

FIG. 19(b)

129

121

FIG. 19(c)

129

121

FIG. 19(d)

129

121

FIG. 19(e)

129

121

FIG. 19(f)

129

121

FIG. 19(g)

129

121

FIG. 19(h)

129

121

FIG. 19(i)

129

121

FIG. 19(j)

129

121

FIG. 19(k)

129

121

FIG. 19(l)

129

121

FIG. 20

110

121 — 129

122 — 123

FIG. 21

110

122 — 123

129

121

FIG. 22(a) 129 121

FIG. 22(b) 129 121

FIG. 22(c) 129 121

FIG. 22(d) 129 121

FIG. 22(e) 129 121

FIG. 22(f) 129 121

FIG. 22(g) 129 121

FIG. 22(h) 129 121

FIG. 22(i) 129 121

FIG. 22(j) 129 121

FIG. 22(k) 129 121

FIG. 22(l) 129 121

FIG. 23(a) 125

FIG. 23(b) 129

FIG. 24

129

135

129

FIG. 25(a)

FIG. 25(b)     110

110
123

122     123

133a

L     133

H     133b
133c     121     W

133a
133b
133c

133

FIG. 25 (c)

133a

133b

133c

133     —— Mountain Fold

---- Valley Fold

**EP 2 809 134 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006064939 A